# FASCICULE DE BREVET EUROPEEN

(11) **EP 2 836 896 B1**
(45) Date de publication et mention de la délivrance du brevet: **20.12.2017**
(21) Numéro de dépôt: 13719939.4
(22) Date de dépôt: 28.03.2013
(51) Int. Cl.: G06F 3/044, H01L 41/08, H03K 17/96, H01L 41/047, H01L 41/113, H01L 41/257, H01L 41/29

(54) **CAPTEUR TACTILE ET PROCEDE DE FABRICATION D'UN TEL CAPTEUR**
BERÜHRUNGSSENSOR UND HERSTELLUNGSVERFAHREN DAFÜR
TOUCH SENSOR AND A FABRICATION METHOD THEREFOR

(30) Priorité: 11.04.2012 FR 1253320
(43) Date de publication de la demande: 18.02.2015
(73) Titulaire: Commissariat à l'Énergie Atomique et aux Énergies Alternatives, 75015 Paris (FR)
(72) Inventeur: ALIANE, Abdelkader, F-38100 Grenoble (FR); BENWADIH, Mohammed, F-94500 Champagny / Marne (FR); HAON, Olivier, F-38960 Saint Etienne De Crossey (FR)
(74) Mandataire: Cabinet Laurent & Charras
(86) Numéro de dépôt international: PCT/FR2013/050673
(87) Numéro de publication internationale: WO 2013/153307

(56) Documents cités:
- EP-A1- 0 528 279
- EP-A2- 0 609 021
- EP-A2- 1 418 491
- EP-A2- 2 075 678
- WO-A1-2011/156447
- KR-B1- 101 133 141
- US-A- 3 691 555
- US-A- 4 688 306
- US-A- 5 336 422
- US-A- 5 494 617
- US-A- 5 505 870
- US-A1- 2006 001 655
- US-A1- 2009 135 031
- US-A1- 2010 068 460
- US-A1- 2010 328 264
- US-A1- 2011 080 368
- US-A1- 2011 095 997
- US-A1- 2011 155 478
- US-A1- 2012 075 201

## Description

### DOMAINE DE L'INVENTION

L'invention a trait aux capteurs dits « tactiles », c'est-à-dire détectant la présence d'un objet à leur surface, et notamment aux capteurs tactiles dits « capacitifs » détectant ladite présence au moyen d'une variation d'une propriété capacitive induite par la présence de l'objet à proximité ou au contact du capteur. L'invention a trait également à un capteur de pression détectant la présence d'une force au contact du capteur au moyen d'une génération d'une tension électrique aux bornes du capteur.

L'invention trouve particulièrement application dans les écrans, les claviers, et les pavés tactiles.

### ETAT DE LA TECHNIQUE

On connaît des capteurs tactiles qui détectent la présence d'un doigt à leur surface par la variation de capacité qui en résulte. Ces capteurs, usuellement désignés sous l'expression de « capteurs tactiles capacitifs », sont par exemple utilisés dans les écrans, les claviers, et les pavés tactiles d'ordinateurs, de téléphones dits « intelligents » (ou « smartphone »), ou encore de tablettes.

De tels capteurs comportent usuellement au moins deux électrodes formées à la surface d'une couche diélectrique, et définissant avec ladite couche une capacité de valeur connue. Cette capacité forme avec un doigt localisé à proximité de, ou au contact du capteur un système capacitif, dont la capacité est différente de celle du capteur seul. La mesure de la différence de capacité résultant de la présence d'un doigt, et sa comparaison à la capacité du capteur seul, permet ainsi de détecter le doigt.

Toutefois, la détection de la présence d'un doigt à proximité ou au contact du capteur ne suffit généralement pas à caractériser une action de l'utilisateur. En effet, l'utilisateur entend usuellement déclencher une action au moyen d'un écran, d'un clavier, ou d'un pavé tactile en pressant effectivement ce dernier. Or, si les capteurs capacitifs « enregistrent » une variation de capacité en présence d'un doigt, ils ne permettent pas de détecter la pression exercée par ce dernier.

Le document WO2011/156447A1 décrit un capteur tactile capacitif et sa méthode de fabrication, le capteur comprenant une couche de matériau piézoélectrique entre les couches d'électrodes du capteur tactile. Cet arrangement permet de mesurer le toucher, la proximité et la pression sur le capteur.

### EXPOSE DE L'INVENTION

Le but de la présente invention est de proposer un capteur capacitif qui détecte également la pression exercée à sa surface par un objet, notamment un doigt.

A cet effet, l'invention a pour objet un capteur tactile comportant une couche de matériau piézoélectrique intercalée entre d'une part, des premier et deuxième éléments conducteurs électriques, et d'autre part au moins un troisième élément conducteur comprenant une surface en regard d'au moins l'un des premier et deuxième éléments conducteurs.

L'expression « en regard » signifie, notamment, que la surface projetée des éléments conducteurs disposés sur une première face de la couche de matériau piézoélectrique, projection réalisée selon un axe orthogonal au plan principal de ladite couche, sur la seconde face de celle-ci, coïncide au moins partiellement avec les éléments conducteurs disposés sur la second face.

En d'autres termes, la couche diélectrique d'un capteur tactile capacitif de l'état de la technique est remplacée par une couche piézoélectrique et est intercalée entre des éléments conducteurs ou « électrodes ». Ainsi, le capteur selon l'invention comporte une première capacité formée par les premier et deuxième éléments conducteurs et la couche piézoélectrique, qui permet une détection capacitive d'un doigt à proximité desdits éléments conducteurs de manière classique, et une seconde capacité formée des éléments conducteurs intercalant la couche piézoélectrique et présentant des surfaces en regard. En appuyant sur le capteur, le matériau piézoélectrique se déforme et libère donc des charges électriques qui sont collectées par les éléments conducteurs en regard, ce qui fait varier la tension entre ces derniers. La variation de tension est ainsi une image de la pression exercée par un objet à la surface du capteur.

Selon un mode de réalisation de l'invention, les premier et deuxième éléments conducteurs comprennent chacun un peigne, et les peignes des premier et deuxième éléments conducteurs sont interdigités, une telle structure permettant de détecter de manière capacitive la présence d'un objet sur une large surface.

Plus particulièrement, la couche de matériau piézoélectrique est intercalée entre d'une part les premier et deuxième éléments conducteurs et d'autre part le troisième élément conducteur et un quatrième élément conducteur, dans lequel les troisième et quatrième éléments conducteurs comprennent chacun un peigne, les peignes des troisième et quatrième éléments conducteurs étant interdigités. En outre, des dents du premier élément conducteur sont disposées en regard de dents du quatrième élément conducteur, et des dents du deuxième élément conducteur sont disposées en regard de dents du troisième élément conducteur. Une telle structure permet de définir une capacité entre chaque paire de dents en regard, ce qui permet d'augmenter la sensibilité du capteur. En outre, le capteur présente une structure symétrique et permet une détection capacitive et de pression sur ses deux faces.

Avantageusement, le premier élément conducteur est connecté électriquement au troisième élément conducteur et, le deuxième élément conducteur est connecté électriquement au quatrième élément conducteur. Ainsi donc, les capacités présentes dans le capteur selon l'invention sont connectées en parallèle. Non seulement le nombre de connexions est minimum, mais en outre il est possible, à l'aide d'une unique tension entre deux bornes du capteur, par exemple deux bornes connectés respectivement aux premier et deuxième éléments conducteurs, de mesurer à la fois les variations de capacité en raison de la présence d'un doigt à proximité du capteur et les variations de tension induites par la libération de charges sous l'effet d'une pression exercée sur le capteur.

Notamment, l'agencement des premier, deuxième, troisième et quatrième éléments conducteurs réalisés sous forme de peignes interdigités et connectés électriquement de cette manière, définit une capacitance maximale entre les faces de la couche de matériau piézoélectrique. En effet, le premier et le troisième éléments conducteurs forment ensemble une première structure en trois dimensions avec des dents alternativement disposées sur une face puis sur l'autre face de la couche piézoélectrique. De même, le deuxième et troisième éléments conducteurs forment ensemble une seconde structure tridimensionnelle dont les dents sont disposées alternativement sur les faces de la couche piézoélectrique. De cette manière, il est obtenu une capacitance verticale élevée, chaque portion de la première structure disposée sur une face de la couche piézoélectrique étant en regard d'une portion correspondante de la seconde structure disposée sur l'autre face de la couche piézoélectrique. La capacité totale résultante, qui est la somme des capacités sur les faces de la couche piézoélectrique et de la capacité entre les faces de celle-ci, est ainsi très élevée. Ceci permet notamment de diminuer la tension électrique d'alimentation entre les deux structures.

Selon un mode de réalisation, des éléments en graphène sont formés dans et/ou au contact d'une part des premier et second éléments conducteurs, et d'autre part, de la couche de matériau piézoélectrique. Des éléments en graphène sont également formés dans et/ou au contact d'une part des deuxième et quatrième éléments conducteurs, et d'autre part, la couche de matériau piézoélectrique, et en regard des éléments en graphène réalisés dans et/ou au contact des premier et deuxième éléments conducteurs.

Le graphène est un matériau dont la conductivité électrique augmente fortement en fonction de la température. Ainsi, lorsqu'un doigt est au contact, ou à proximité des éléments en graphène, ceux-ci s'échauffent, ce qui augmente leur conductivité, et fait donc chuter leur résistance électrique. Les charges libérées par le matériau piézoélectrique sont alors collectées de manière plus efficace par les éléments de graphène, ce qui augmente donc la sensibilité du capteur.

Plus particulièrement, les éléments comportant du graphène sont des plots de graphène réalisés dans les éléments conducteurs. Il est ainsi possible de réaliser un réseau de plots en graphène, et donc de s'assurer qu'au moins une partie d'entre eux est échauffée par la présence d'un doigt. En variante, les éléments conducteurs sont entièrement constitués de graphène.

Selon un mode de réalisation de l'invention, le matériau piézoélectrique est semi-cristallin ou cristallin. Plus particulièrement, le matériau piézoélectrique est un matériau ferroélectrique cristallin polarisé en moyenne perpendiculairement aux surfaces en regard entre d'une part les premier et deuxième éléments conducteurs et d'autre part le au moins un troisième élément conducteur.

Dans des applications privilégiées, l'empilement de la couche piézoélectrique et des éléments conducteurs est formé sur un substrat flexible et/ou recouvert d'une couche flexible de protection, c'est-à-dire un substrat et une couche qui se déforment sans casser, par exemple un substrat et une couche en matière plastique. Pour des raisons évidentes de robustesse du capteur, il est préférable que la couche piézoélectrique ne se désolidarise pas du substrat ou de la couche flexible lors des déformations appliquées au capteur. Une structure cristalline est usuellement plus déformable qu'une structure amorphe, et présente donc un risque moindre de se désolidariser du substrat et de la couche flexible.

En outre, le capteur peut voir sa température fortement varier au cours de son fonctionnement. Une autre source de faiblesse mécanique provient de la différence de coefficient thermique d'expansion existant entre la couche piézoélectrique, le substrat et la couche de protection, que le substrat et la couche soient flexibles ou non. Notamment, si en raison d'une variation importante de température, les dilations et les contractions de ces divers éléments diffèrent de manière trop importante, on peut observer leur désolidarisation.

Certains matériaux ferroélectriques présentent une structure cristalline ainsi qu'une polarisation électrique spontanée, notamment les ferroélectriques pyroélectriques polaires cristallins. En polarisant ces ferroélectriques de manière permanente par application d'un champ électrique approprié, ceux-ci présentent alors une propriété piézoélectrique. Par exemple, la couche de matériau piézoélectrique est obtenue par application, entre deux faces d'une couche de matériau ferroélectrique cristallin pyroélectrique polaires, d'un champ électrique d'une intensité comprise entre 30 MV/m (Méga Volt par mètre) et 60 MV/m entre 1 heure et 8 heures, et en portant la couche de matériau ferroélectrique à une température inférieure à la température de Curie dudit matériau.

Il est ainsi obtenu une couche piézoélectrique cristalline ayant une bonne tenue mécanique en raison de sa nature cristalline avec le substrat et la couche flexible. En outre, on observe que de tels matériaux ferroélectriques présentent un coefficient d'expansion thermique proche des matériaux couramment utilisés pour les substrats flexibles, notamment les substrats en plastique, tels que le polynaphtalate d'éthylène (« PEN ») et le poly(éthylène téréphtalate) (« PET »).

Notamment, le matériau ferroélectrique est du polyfluorure de vinylidène (« PVDF ») en phase béta qui est une phase présentant des caractéristiques piézoélectriques, un copolymère de polyfluorure de vinylidène : Poly (VDF-TrFe) poly(vinylidene fluoride - trifluoroethylene), du titano-zirconate de plomb ou du titanate de baryum.

Selon un mode de réalisation, la couche de piézoélectrique est réalisée sur un substrat flexible, notamment un substrat en plastique, tel qu'un substrat en polyéthylène naphtalate (« PEN ») ou en poly(éthylène téréphtalate) (« PET »).

L'invention a également pour objet un procédé de fabrication d'un capteur tactile du type précité.

Plus particulièrement, l'invention a également pour objet un procédé de fabrication d'un capteur tactile, consistant :
▪ à réaliser une couche de matériau ferroélectrique cristallin ou semi-cristallin intercalée entre d'une part des premier et deuxième éléments conducteurs et d'autre part au moins un troisième élément conducteur comprenant une surface en regard d'au moins l'un des premièr et deuxième éléments conducteurs ; et
▪ à appliquer un champ électrique entre d'une part les premier et second éléments conducteurs et d'autre part le au moins troisième élément conducteur, le champ électrique ayant une intensité comprise entre 30 MV/m et 60 MV/m et étant appliqué entre 1 heure et 8 heures, en chauffant la couche de matériau ferroélectrique à une température inférieure à la température de Curie dudit matériau.

Selon un mode de réalisation :
▪ la réalisation de la couche piézoélectrique intercalée entre les éléments conducteurs comprend la réalisation de ladite couche intercalée entre d'une part les premier et deuxième éléments conducteurs et d'autre part le troisième élément conducteur et un quatrième élément conducteur, chacun des éléments conducteurs comportant un peigne, les peignes des premier et deuxième éléments conducteurs étant interdigités, les peignes des troisième et quatrième éléments conducteurs étant interdigités, des dents du premier élément conducteur étant disposées en regard de dents du quatrième élément conducteur, et des dents du deuxième élément conducteur étant disposées en regard de dents du troisième élément conducteur,
▪ le procédé comporte en outre la réalisation d'un premier élément de connexion connectant électriquement le premier élément conducteur et le troisième élément conducteur, et d'un second élément de connexion connectant le deuxième élément conducteur et le quatrième élément conducteur ; et
▪ le champ électrique est obtenu en appliquant une différence de potentiels entre les premier et second éléments de connexion.

Selon un mode de réalisation, le matériau ferroélectrique comporte du polyfluorure de vinylidène, un copolymère de polyfluorure de vinylidène, notamment un poly (VDF-TrFe), du titano-zirconate de plomb, du titanate de baryum ou un mélange de ceux-ci.

En appliquant le champ électrique entre les éléments conducteurs constitutifs des capacités du capteur, on obtient ainsi une polarisation optimale du matériau ferroélectrique, ladite polarisation est dû à l'orientation des dipôles dans le matériau ferroélectrique suite à l'application d'un champ électrique.

Selon un mode de réalisation, la couche de matériau ferroélectrique intercalée entre les éléments conducteurs est réalisée :
▪ en formant le au moins un troisième élément conducteur sur une face d'un substrat flexible ;
▪ en formant la couche de matériau ferroélectrique sur le troisième élément conducteur et le substrat ; et
▪ en formant les premier et deuxième éléments conducteurs sur la couche de matériau ferroélectrique.

### BREVE DESCRIPTION DES FIGURES

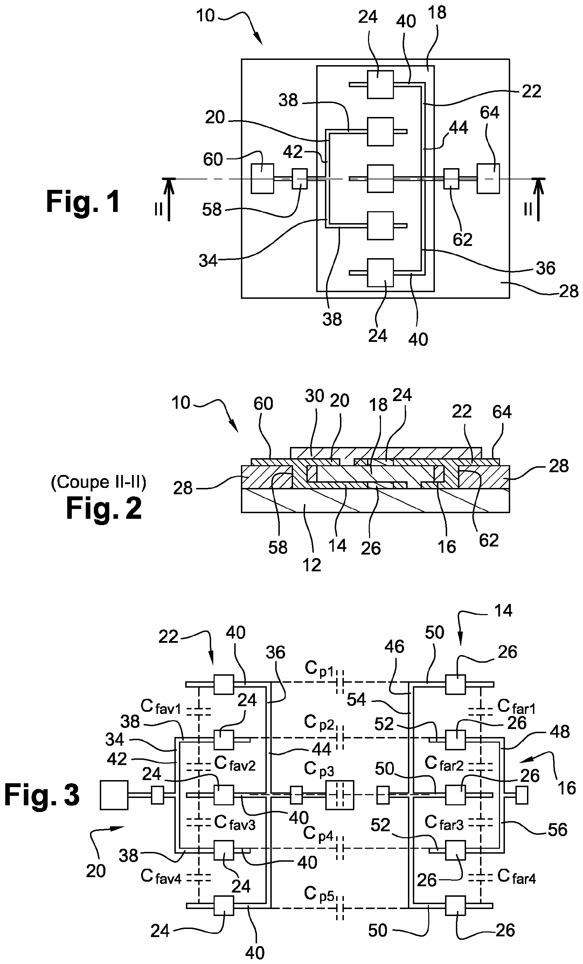

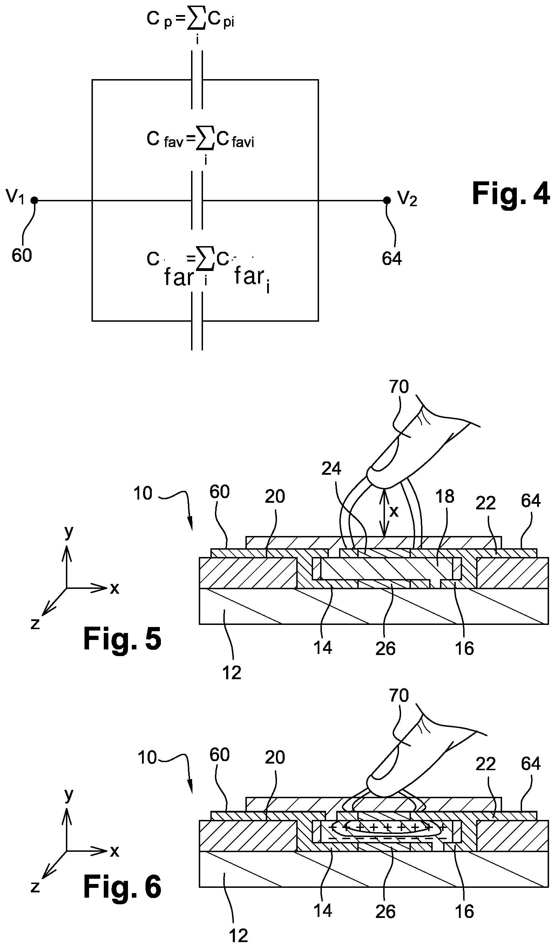

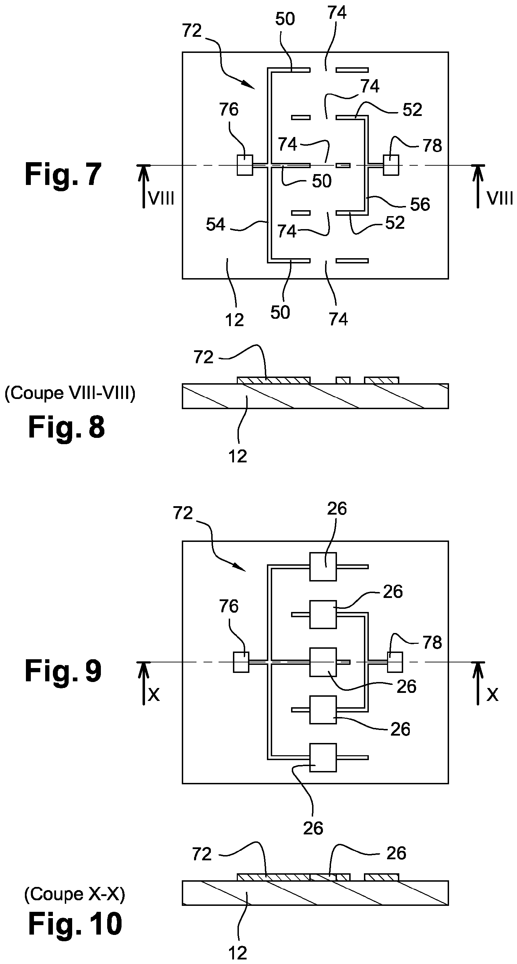

L'invention sera mieux comprise à la lecture de la description qui suit, donnée uniquement à titre d'exemple, et réalisée en relation avec les dessins annexés, dans lesquels des références identiques désignent des éléments identiques ou analogues, et dans lesquels :
▪ la figure 1 est une vue schématique de dessus d'un capteur selon l'invention ;
▪ la figure 2 est une vue schématique en coupe dans le plan II-II du capteur de la figure 1;
▪ la figure 3 est une vue de dessus des électrodes avant (portion gauche de la figure) et arrière (portion droite de la figure) du capteur des figures 1 et 2 illustrant également les différentes capacités présentes dans ce capteur entre les différents parties d'électrodes en présence;
▪ la figure 4 est un schéma électrique équivalent du capteur des figures 1 et 2 ;
▪ la figure 5 est une vue schématique en coupe dans le plan II-II illustrant un mode de détection capacitif du capteur des figures 1 et 2 ;
▪ la figure 6 est une vue schématique en coupe dans le plan II-II illustrant un mode de détection combinant une détection capacitive et de pression du capteur des figures 1 et 2 ; et
▪ les figures 7 à 20 sont des vues schématiques de dessus et en coupe illustrant un procédé de fabrication d'un capteur selon l'invention.

### DESCRIPTION DETAILLEE DE L'INVENTION

En se référant aux figures 1 et 2, un capteur tactile selon l'invention comporte :
▪ un substrat **12,** notamment un substrat flexible en plastique, par exemple un substrat constitué de Poly éthylène naphtalate (« PEN ») ou de poly éthylène téréphtalate) (« PET »), et d'une épaisseur comprise entre 25 et 200 micromètres ;
▪ des électrodes métalliques **14, 16** réalisées sur le substrat **12,** ou électrodes « arrière », par exemple d'une épaisseur comprise entre 30 et 500 nanomètres, et constituées d'or, d'argent, de platine, de cuivre, de nickel, de tungstène, de titane ou autres ;
▪ une couche de matériau piézoélectrique **18** réalisée sur les électrodes arrière **14, 16,** notamment une couche d'épaisseur comprise entre 1 et 10 micromètres ;
▪ des électrodes métalliques **20, 22** réalisées sur la couche piézoélectrique **18,** ou électrode « avant », par exemple d'une épaisseur comprise entre 2 et 15 micromètres, et constituées d'or, d'argent, de platine, de cuivre, de nickel, de tungstène, de titane ou autres. Les électrodes avant **20, 22** sont disposées en regard des électrodes **14, 16** de manière à présenter avec celles-ci une surface en regard ;
▪ des plots en graphène **24, 26,** réalisés dans les électrodes avant **18** et arrière **14** et au contact avec la couche piézoélectrique **18** ; et
▪ une encapsulation des électrodes avant **20, 22** et de la couche piézoélectrique **18,** comportant une couche de protection latérale **28** réalisée sur le substrat **12** et une couche de protection supérieure **30** (non représentée sur la figure 1) réalisée sur les électrodes avant **20, 22** et la couche piézoélectrique **18,** et définissant une surface tactile. Les couches de protection **28** et **30** sont constituées d'un matériau isolant, notamment une couche diélectrique de faible constante diélectrique, par exemple de type polymère fluoré ou polyimide. Avantageusement, la couche de protection **30** est flexible de manière à se déformer sous la pression exercée par un doigt et présente à cet effet une épaisseur comprise entre 100 nm à 5 µm.

Les électrodes avant **20, 22** comprennent avantageusement chacune un peigne **34, 36.** Les peignes **34, 36** des électrodes avant sont interdigités, des dents **38** d'un peigne **34** étant intercalées entre des dents **40** de l'autre peigne **36.**

Par exemple, les peignes **34, 36** ont des dents **38, 40** parallèles et de même longueur, fixées respectivement à des armatures **42, 44.**

Par la suite, le peigne **34** sera dénommé peigne « de gauche » en raison de son armature **42** disposée à gauche sur les figures, et le peigne **36** sera désigné peigne de « droite » en raison de son armature **44** disposée à droite sur les figures.

En se référant à la figure 3, qui illustre en vue de dessus les électrodes avant (à gauche de la figure 3) et les électrodes arrière (à droite de la figure 3), les électrodes arrière **14, 16** comprennent également chacune un peigne **46, 48,** les peignes **46, 48** des électrodes arrière sont interdigités, des dents **50** d'un peigne **46** étant intercalées entre des dents **52** de l'autre peigne **48.**

Les dents **50, 52** des peignes **46, 48** sont respectivement fixées à des armatures **54, 56.** Par la suite, le peigne **46** sera dénommé peigne « de gauche » en raison de son armature **54** disposée à gauche sur les figures, et le peigne **48** sera désigné peigne de « droite » en raison de son armature **56** disposée à droite sur les figures.

Le peigne de gauche avant **34** est identique, à une réflexion près, au peigne de droite arrière **48** et est disposé en regard de celui-ci. De même, le peigne de droite avant **36** est identique, à une réflexion près, au peigne de gauche arrière 46 et est disposé en regard de celui-ci. Ainsi, les dents **38, 40** des peignes de droite et de gauche avant **34, 36** sont diposées en regard des dents **50, 52** des peignes de gauche et de droite arrière **46, 48** respectivement.

Le capteur **10** comporte en outre des éléments de connexion connectant électriquement les peignes de gauche avant et arrière **34, 46,** notamment un via métallisé traversant **58** formé dans l'épaisseur de la couche de protection **28,** ainsi qu'une plage métallique **60** connectée électriquement aux peignes de gauche **34, 46** et formée sur la couche de protection **28.** De manière analogue, le capteur **10** comporte des éléments de connexion connectant électriquement les peignes de droite avant et arrière **36, 48,** notamment un via métallisé traversant **62** formé dans l'épaisseur de la couche de protection **28,** ainsi qu'une plage métallique **64** connectée électriquement aux peignes de droite **36, 48** et formée sur la couche de protection **28.**

Un plot de graphène **24, 26** est par ailleurs réalisé dans chacune des dents des peignes **34, 36, 46, 48,** un plot de graphène d'un peigne avant étant de préférence disposé en regard d'un plot de graphène d'un peigne arrière, ce qui permet de conserver la symétrie globale du capteur **10.**

De manière avantageuse, les plots en graphène **24, 26** présente une aire comprise entre 50 µm x 50 µm et 500 µm x 500 µm, et est donc particulièrement adaptée à la dimension du capteur. Comme cela est connu en soi, le graphène est un matériau dont la conductivité électrique augmente fortement avec la température. Ainsi, à mesure que la température augmente, par exemple en raison de la présence d'un doigt, les charges électriques libérées par le matériau piézoélectrique de la couche **18** sous l'effet d'une pression exercée sur celle-ci sont localement très nombreuses et sont collectées plus aisément au moyen desdits plots, ce qui augmente d'autant la capacité électrique de l'ensemble tel que cela sera décrit plus en détail par la suite.

Comme cela est illustré à la figure 3, la structure des électrodes venant d'être décrite définit donc en combinaison avec la couche piézoélectrique **18** :
▪ une capacité *C_{favi}* entre chaque paire de dents adjacentes **38, 40** des peignes avant 34, 36 ;
▪ une capacité *C_{fari}* entre chaque paire de dents adjacentes **50, 52** des peignes arrière **46, 48** ;
▪ une capacité *Cₚᵢ* entre chaque paire de dents **38, 52** en regard des peignes avant de gauche **34** et arrière de droite **48** et entre chaque paire de dents **40, 50** en regard des peigne avant de droite **36** et arrière de gauche **46** ;
▪ une connexion en parallèle de l'ensemble des capacités *C_{favi}*, *C_{fari}* , *Cₚᵢ* ainsi définies.
La figure 4 illustre un schéma électrique équivalent du capteur **10** venant d'être décrit entre les plages métalliques **60, 64.** Ce schéma illustre trois capacités en parallèle, à savoir :
   ▪ une première capacité *Cₚ* égale à la somme ∑*Cₚᵢ* des capacités *Cₚᵢ*,
   ▪ une deuxième capacité *C_{fav}* égale à la somme ∑*C_{favi}* des capacités *C_{favi}* , et
   ▪ une troisième capacité *C_{far}* égale à la somme ∑*C_{fari}* des capacités *C_{fari}.*

On note notamment qu'il est formé deux électrodes tridimensionnelles indépendantes, à savoir une première électrode formée du peigne avant gauche **34,** du peigne arrière gauche **46** et de l'élément de connexion **58,** et une seconde électrode formée du peigne avant droit 36, du peigne arrière droit **48** et de l'élément de connexion **62.** Chacune de ces électrodes comporte des dents qui sont alternativement disposées sur la face avant et sur la face arrière de la couche piézoélectrique **18** et pour chacun des portions d'une électrode disposée sur une face de la couche **18,** il existe une portion correspondante en regard sur l'autre face la couche **18.** De cette manière, la capacité « verticale » *Cₚ* est maximale. De même pour chaque face de la couche **18,** une portion de la première électrode est en regard d'au moins une, et deux concernant les dents non extrêmes, portion correspondante de la seconde électrode. Les capacités « horizontales » *C_{fav}* et *C_{far}* sont chacune maximale. Il en résulte une capacité globale entre les deux électrodes qui est maximale. Ceci permet notamment, si souhaité, de diminuer les tensions d'alimentation entre ces deux électrodes.

La couche piézoélectrique **18** est avantageusement une couche réalisée en matériau ferroélectrique semi-cristallin ou cristallin polarisé, notamment un matériau ferroélectrique à base de PVDF (polyfluorure de vinylidène) et/ou de copolymères de PVDF, par exemple un poly (VDF-TrFe) avec des compositions adaptées, de PZT (titano-zirconate de plomb), de BaTiO₃ (titanate de baryum), de PbTiO₃ (titanate de plomb), ou d'un mélange de ces matériaux.

De manière avantageuse, le matériau ferroélectrique de la couche **18** est polarisé, en moyenne, selon une direction perpendiculaire aux plans dans lesquels les électrodes avant **20, 22** et arrière **14, 16** sont réalisées. Par exemple, une telle polarisation est obtenue de manière permanente en appliquant entre les deux faces de la couche **18** un champ électrique d'une intensité comprise entre 30 MV/m et 60 MV/m sur l'épaisseur de la couche **18,** entre 1 heure et 8 heures, et en portant la couche **18** à une température inférieure à la température de Curie du matériau ferroélectrique.

Pour plus de détails concernant la polarisation d'un matériau ferroélectrique, on pourra par exemple se reporter au document US 5 494 617.

De cette manière, le matériau ferroélectrique est polarisé perpendiculairement aux surfaces en regard des électrodes avant et arrière, ce qui permet d'obtenir dans ladite direction un effet piézoélectrique important. Notamment, le champ électrique est appliqué aux moyens des électrodes avant et arrière elles-mêmes en connectant les plages métalliques **60, 64** à une source de tension. De cette manière, les dipôles du matériau ferroélectrique de la couche **18** sont orientés selon les lignes de champ électrique entre ces électrodes, ce qui optimise l'effet piézoélectrique.

Le capteur selon l'invention combine ainsi deux modes de détection différents pour détecter la présence d'un doigt à sa surface, à savoir un mode de détection capacitif et un mode de détection piézoélectrique. Plus particulièrement, la tension entre les plages **60, 64** varie en fonction de la variation de capacité liée à la présence d'un doigt et la libération de charges par la couche **18** sous l'effet d'une pression exercée sur celle-ci.

Notamment, lorsqu'il n'y a pas d'objet à proximité du capteur **10,** ce dernier présente donc une capacité de valeur prédéterminée entre les plages **60, 64.** En revanche, lorsqu'un objet, notamment un doigt **70,** se rapproche des électrodes avant **20, 22,** ou des électrodes arrière **14, 16,** sans appuyer sur le capteur **10,** comme cela est illustré à la figure schématique en coupe 5, une capacité nouvelle, dont la valeur dépend de la distance x entre l'objet **70** et le capteur **10,** est ajoutée en parallèle des capacités *Cₚ*, *C_{fav}* et *C_{far}* déjà présentes dans le capteur **10.** La capacité totale entre les plages **60** et **64** est donc modifiée. En connectant les plages **60** et **64** à un dispositif de mesure de capacité, il est ainsi possible de mesurer la variation de capacité entre lesdites plages **60, 64,** et donc de détecter la présence du doigt **70.** De tels dispositifs, ou « capacimètres », sont classiques et ne seront donc pas décrits plus en détail.

En mode de détection piézoélectrique, après l'alignement des dipôles dans le matériau ferroélectrique, ce matériau est rendu piézoélectrique, c'est-à-dire que des charges électriques sont générées lorsqu'une pression est exercée sur la couche **18** suivant la direction de polarisation. Ainsi lorsqu'un objet, par exemple un doigt **70,** appuie sur la face avant ou arrière du capteur **10,** tel que cela est illustré à la figure schématique en coupe 7, il en résulte une variation de la tension entre les plages métalliques **60, 64.** En connectant les plages **60** et **64** à un dispositif de mesure de tension, il est ainsi possible de mesurer ladite variation de tension, et donc de détecter la pression exercée par un objet sur le capteur **10,** notamment un doigt **70.**

En outre, lorsqu'un doigt **70** est en contact avec le détecteur sans appuyer sur celui-ci au dessus d'un plot de graphène **24, 26,** ce dernier subit un chauffage local important en raison de la très bonne conductivité thermique du graphène, ce qui fait chuter la résistance électrique du graphène. Ce faisant, il est obtenu un meilleur passage des électrons au travers de l'interface entre le matériau piézoélectrique et le plot de graphène et par conséquent un champ électrique élevé à cette interface. En outre, avec l'effet de la température au niveau de cette interface, on constate que la constante piézoélectrique du matériau piézoélectrique augmente, ce qui augmente corrolairement la sensibilité de ce capteur lorsque le doigt exerce une pression sur le capteur. De plus, le graphène a pour effet d'augmenter localement la capacitance du capteur.

Il va à présent être décrit en relation avec les figures 7 à 20 un procédé de fabrication d'un capteur tactile selon l'invention.

Le procédé débute par la réalisation d'un substrat flexible **12** en plastique, par exemple un substrat constitué de poly éthylène naphtalate (« PEN ») ou de poly éthylène téréphtalate (« PET ») d'une épaisseur comprise entre 25 et 200 micromètres, puis se poursuit par le dépôt sur le substrat **12,** par exemple par pulvérisation ou évaporation physique, d'une métallisation **72** sur une épaisseur comprise entre 30 et 500 nanomètres, par exemple de l'or (Au), de l'argent (Ag), du platine (Pt), du cuivre (Cu), du nickel (Ni), du tungstène (W), ou du titane (Ti).

La métallisation **72** comporte deux armatures **54, 56** à partir desquelles sont réalisées des dents **50, 52** parallèles, de même longueur et intercalées. Les dents **50, 52** ne sont pas complétées et comportent des manques **74** aux emplacements désirés pour les plots de graphène. Chacune des armatures **54, 56** est par ailleurs raccordée à une plage métallique **76, 78** (figure 7 en vue de dessus et figure 8 en coupe selon le plan VIII-VIII).

Lors d'une étape suivante, des plots de graphène conducteur **26,** d'une épaisseur comprise entre 100 nm et quelques µm, sont déposés, par exemple par sérigraphie, sur les manques **74** formés dans les dents **50, 52** (figure 9 en vue de dessus et figure 10 en coupe selon le plan X-X). Les électrodes arrière **14, 16** décrites précédemment sont ainsi obtenues.

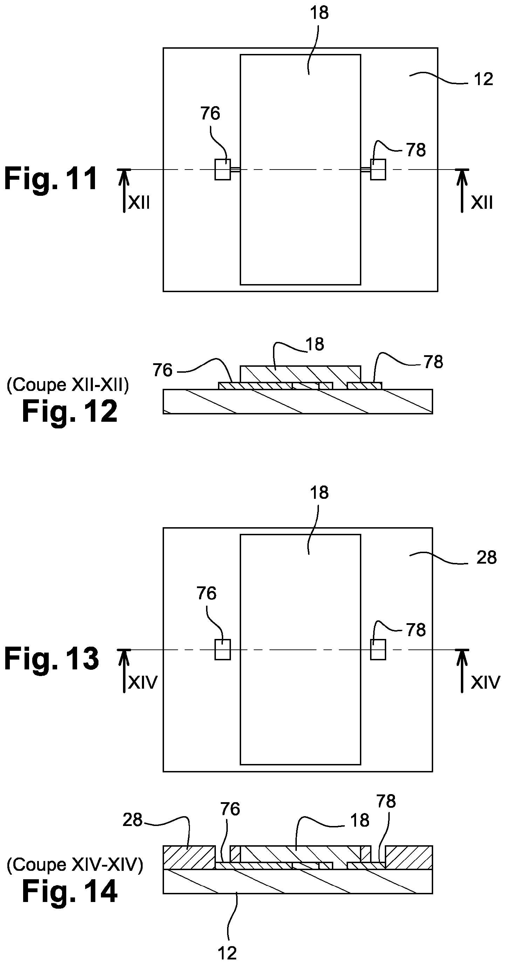

Le procédé se poursuit par le dépôt, par exemple par sérigraphie ou impression jet d'encre, d'une couche piézoélectrique **18,** d'une épaisseur comprise entre 1 et 10 micromètres, sur les électrodes arrière **14, 16** en laissant libre les plages métalliques **76, 78** (figure 11 en vue de dessus et figure 12 en coupe selon le plan XII-XII). Le matériau piézoélectrique est avantageusement un ferroélectrique cristallin polaire, notamment du PVDF, un copolymère de PVDF, du PZT, du BaTiO₃ ou du PbTiO₃.

Une couche **28** de diélectrique d'isolation est ensuite réalisée sur le substrat **12** autour de, et à hauteur de la couche **18** en laissant libre les plages métalliques **76, 78,** et plus particulièrement une couche diélectrique non ferroélectrique, comme par exemple une couche diélectrique fluoropolymère à faible constante diélectrique (figure 13 en vue de dessus et figure 14 en coupe selon le plan XIV-XIV). Par exemple, la couche **28** est déposée pleine plaque par sérigraphie ou impression jet d'encre avec des ouvertures de vias pour dégager les plages **76, 78.**

Le procédé se poursuit alors par le dépôt sur la couche **18** et la couche **28,** par exemple par pulvérisation ou évaporation physique, d'une métallisation **80** sur une épaisseur comprise entre 2 et 15 micromètres, par exemple de l'or (Au), de l'argent (Ag), du platine (Pt), du cuivre (Cu), du nickel (Ni), du tungstène (W), ou du titane (Ti).

La métallisation **80** comporte deux armatures **42, 44** à partir desquelles sont réalisées des dents **38, 40** parallèles, de même longueur et intercalées. Les dents **38, 40** ne sont pas complétées et comportent des manques **82** aux emplacements désirés pour les plots de graphène **24.** Les armatures **42, 44** sont par ailleurs respectivement raccordées aux plages métalliques **76, 78,** la métallisation **80** remplissant les ouvertures réalisées dans la couche **28** au droit des plages **76, 78.**

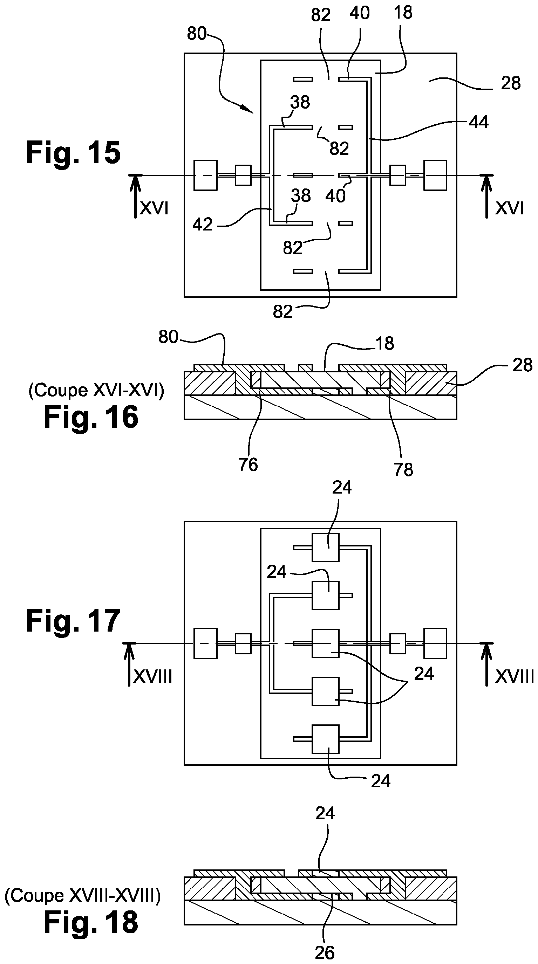

Enfin, la métallisation **80** comporte des plages **60, 64** respectivement raccordées aux armatures **42, 44** (figure 15 en vue de dessus et figure 16 en coupe selon le plan XVI-XVI).

Des plots de graphène conducteur **24,** d'une épaisseur comprise entre 100 nm et 10 µm, sont ensuite déposés, par exemple par sérigraphie, sur les manques **82** formés dans les dents **38, 40** (figure 17 en vue de dessus et figure 18 en coupe selon le plan XVIII-XVIII). Les électrodes avant **20, 22** décrites précédemment sont ainsi obtenues.

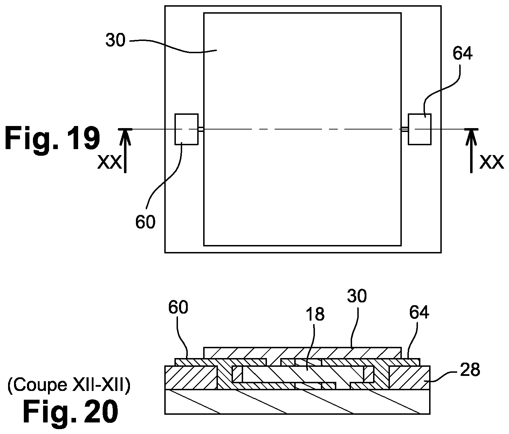

Une couche flexible de protection et d'isolation **30** diélectrique de faible constante diélectrique, par exemple une couche de polymère fluoré ou de polyimide d'une épaisseur comprise entre 100 nm et 5 µm, est ensuite déposée sur les électrodes avant **20, 22,** la couche **18** et sur la couche de protection **28,** en laissant dégagées les plages métalliques **60, 64** (figure 19 en vue de dessus et figure 20 en coupe selon le plan XX-XX).

Le procédé se termine alors par l'application d'une tension entre les plages métalliques **60, 64,** par exemple au moyen d'une source de tension, de manière à définir entre les électrodes avant et arrière un champ électrique ayant une intensité comprise entre 30 MV/m et 60 MV/m sur l'épaisseur de la couche **18.** La tension, et donc le champ, est appliqué entre 1 heure et 8 heures, et le capteur est chauffé à une température inférieure à la température de Curie dudit matériau, par exemple en disposant le capteur sur un support chauffant régulé en température. Le matériau ferroélectrique acquiert ainsi des propriétés piézoélectriques décrites précédemment.

Il a été décrit un mode de réalisation d'un capteur selon l'invention, dans lequel les électrodes avant et arrière comprennent des peignes interdigités et disposés en regard. La géométrie, la dimension des peignes ainsi que le nombre de dents sont avantageusement choisis pour régler les capacités en présence dans le capteur.

De même, le capteur peut, en variante, posséder une seule électrode en face arrière disposant d'une surface en regard des électrodes disposées en face avant.

De même, il a été décrit un schéma de connexion des capacités en parallèle. En variante, les électrodes ne sont pas connectées entre elles et sont soumises à un potentiel qui leur est propre.

De même, il a été décrit une couche piézoélectrique réalisée à partir d'un matériau ferroélectrique cristallin polarisé. En variante, la couche de piézoélectrique peut être réalisée en un matériau piézoélectrique quelconque, ou en un matériau piézoélectrique cristallin non ferroélectrique.

De même, il a été décrit des plots de graphène réalisés dans les électrodes avant et arrière. En variante, seule les électrodes avant comprennent de tels plots.

En variante également, les plots de graphène sont réalisés sur la couche piézoélectrique et au contact des électrodes sans en faire partie.
En variante également, les électrodes avant et/ou arrière sont constituées de graphène.

## Revendications

1. Capteur tactile (10) comportant une couche de matériau piézoélectrique (18) intercalée entre d'une part, des premier et deuxième éléments conducteurs électriques (20, 22), et d'autre part, au moins un troisième élément conducteur (14, 16) comprenant une surface en regard d'au moins l'un des premier et deuxième conducteurs (20, 22); ***caractérisé* en ce que** :
les premier et deuxième éléments conducteurs électriques (20, 22) comprennent chacun un peigne (34, 36), et dans lequel les peignes (34, 36) des premier et deuxième éléments conducteurs (20, 22) sont interdigités ;
**en ce que** la couche de matériau piézoélectrique (18) est intercalée entre d'une part les premier et deuxième éléments conducteurs électriques (20, 22) et d'autre part, le troisième élément conducteur et un quatrième élément conducteur (14, 16),
**en ce que** les troisième et quatrième éléments conducteurs électriques (14, 16) comprennent chacun un peigne (46, 48), les peignes (46, 48) des troisième et quatrième éléments conducteurs (14, 16) étant interdigités,
**en ce que**:
- des dents (38) du premier élément conducteur (20) sont disposées en regard de dents (52) du quatrième élément conducteur (16); et
- des dents (40) du deuxième élément conducteur (22) sont disposées en regard de dents (50) du troisième élément conducteur (14) ;
et **en ce que** le premier élément conducteur (20) est connecté électriquement au troisième élément conducteur (14), et dans lequel le deuxième élément conducteur (22) est connecté électriquement au quatrième élément conducteur (16).

2. Capteur tactile selon la revendication 1, dans lequel des éléments en graphène (24) sont formés dans et/ou au contact d'une part des premier et second éléments conducteurs électriques (20, 22), et d'autre part de la couche de matériau piézoélectrique (18).

3. Capteur tactile selon la revendication 2, dans lequel des éléments en graphène (26) sont formés dans et/ou au contact d'une part des deuxièmes et quatrième éléments conducteurs (14, 16) et d'autre part de la couche de matériau piézoélectrique (18), et en regard des éléments en graphène (24) réalisés dans et/ou au contact des premier et deuxième éléments conducteurs (20, 22).

4. Capteur tactile selon l'une des revendications 2 et 3, dans lequel les éléments (24, 26) comportant du graphène sont des plots de graphène réalisés dans les éléments conducteurs (14, 16, 20, 22).

5. Capteur tactile selon l'une quelconque des revendications précédentes, dans lequel le matériau piézoélectrique (18) est un matériau ferroélectrique cristallin ou semi-cristallin polarisé en moyenne perpendiculairement aux surfaces en regard entre d'une part les premier et deuxième éléments conducteurs électriques (20, 22) et d'autre part le au moins un troisième élément conducteur (14, 16).

6. Capteur tactile selon l'une quelconque des revendications précédentes, dans lequel le matériau piézoélectrique (18) est un matériau ferroélectrique cristallin ou semi-cristallin polarisé selon des lignes de champ électrique apparaissant entre les surfaces en regard entre d'une part les premier et deuxième éléments conducteurs électriques (20, 22) et d'autre part le au moins un troisième élément conducteur (14, 16) lorsqu'une différence de potentiels est appliquée entre lesdites surfaces en regard.

7. Capteur tactile selon l'une des revendications 5 et 6, dans lequel le matériau ferroélectrique (18) comporte du polyfluorure de vinylidène, un copolymère de polyfluorure de vinylidène, notamment du poly (VDF-TrFe), du titano-zirconate de plomb, du titanate de baryum ou un mélange de ceux-ci.

8. Capteur tactile selon l'une quelconque des revendications précédentes, dans lequel la couche de piézoélectrique (18) est réalisée sur un substrat flexible (12).

9. Procédé de fabrication d'un capteur tactile selon l'une quelconques des revendications précédentes, consistant :
▪ à réaliser une couche de matériau ferroélectrique cristallin ou semi-cristallin (18) intercalée entre d'une part les premier et deuxième éléments conducteurs électriques (20, 22) et d'autre part les troisième et quatrième éléments conducteurs (14, 16); et à appliquer un champ électrique entre d'une part les premier et second éléments conducteurs électriques (20, 22) et d'autre part le au moins troisième élément conducteur (14, 16), le champ électrique ayant une intensité comprise entre 30 MV/m et 60 MV/m et étant appliqué entre 1 heure et 8 heures, en chauffant la couche de matériau ferroélectrique à une température inférieure à la température de Curie dudit matériau.

10. Procédé de fabrication d'un capteur tactile selon la revendication 9, dans lequel :
▪ on réalise un premier élément de connexion (58) connectant électriquement le premier élément conducteur (20) et le troisième élément conducteur (14) et un second élément de connexion (62) connectant le deuxième élément conducteur (22) et le quatrième élément conducteur (16); et
▪ le champ électrique est obtenu en appliquant une différence de potentiels entre les premier et second éléments de connexion (58, 62).

11. Procédé de fabrication d'un capteur tactile selon la revendication 9 ou 10, dans lequel le matériau ferroélectrique (18) comporte du polyfluorure de vinylidène, un copolymère de polyfluorure de vinylidène, notamment du poly (VDF-TrFe), du titano-zirconate de plomb, du titanate de baryum ou un mélange de ceux-ci.

12. Procédé de fabrication d'un capteur tactile selon la revendication 9, 10 ou 11, dans lequel la couche de matériau ferroélectrique (18) intercalée entre les éléments conducteurs est réalisée :
▪ en formant le au moins un troisième élément conducteur (14, 16) sur une face d'un substrat flexible (12) ;
▪ en formant la couche de matériau ferroélectrique (18) sur le troisième élément conducteur (14, 16) et le substrat (12); et
▪ en formant les premier et deuxième éléments conducteurs (20, 22) sur la couche de ferroélectrique (18).

## Patentansprüche

1. Berührungssensor (10), umfassend eine Schicht aus piezoelektrischem Material (18), die zwischen einerseits einem ersten und einem zweiten elektrisch leitenden Element (20, 22) andererseits mindestens einem dritten leitenden Element (14, 16) mit einer Oberfläche zu mindestens einem der ersten und zweiten leitenden Elemente (20, 22) angeordnet ist,
***dadurch gekennzeichnet, dass;***
das erste und das zweite leitende Element (20, 22) jeweils einen Kamm (34, 36) umfassen, in denen die Kämme (34, 36) des ersten und zweiten leitenden Elementes (20, 22) miteinander verzahnt sind;
dass die Schicht aus piezoelektrischem Material (18) zwischen ersten dem ersten und zweiten leitenden Element (20, 22) und andererseits dem dritten leitenden Element und einem vierten leitenden Element (14, 16) angeordnet ist,
dass das dritte und vierte leitende Element (14, 16) jeweils einen Kamm (46, 48) umfassen und die Kämme (46, 48) des dritten und vierten leitenden Elementes (14, 16) miteinander verzahnt sind;
- dass Zähne (38) des ersten leitenden Elementes (20) gegenüber Zähnen (52) des vierten leitenden Elementes (16) angeordnet sind; und
- dass Zähne (40) des zweiten leitenden Elementes (22) gegenüber Zähnen (50) des dritten leitenden Elementes (14) angeordnet sind;
und dass das erste leitende Element (20) mit dem dritten leitenden Element (14) elektrisch verbunden ist und dass das zweite leitende Element (22) mit dem vierten leitenden Element (16) elektrisch verbunden ist.

2. Berührungssensor gemäß Anspruch 1, in dem Graphenelemente (24) in einerseits dem ersten und dem zweiten leitenden Element (20, 22) und andererseits der Schicht aus piezoelektrischem Material (18) gebildet werden und/oder im Kontakt damit sind.

3. Berührungssensor gemäß Anspruch 2, in dem Graphenelemente (26) in einerseits dem zweiten und dem vierten leitenden Element (14, 16) und andererseits der Schicht aus piezoelektrischem Material (18) geformt werden und/oder im Kontakt damit sind und gegenüber den Graphenelementen (24), in dem ersten und dem zweiten leitenden Element (20, 22) ausgeführt werden und/oder im Kontakt damit sind.

4. Berührungssensor gemäß einem der vorstehenden Ansprüche 2 und 3, in dem die Graphen enthaltenden Elemente (24, 26) Graphenplots sind, die in den leitenden Elementen (14, 16, 20, 22) ausgeführt sind.

5. Berührungssensor gemäß einem der vorstehenden Ansprüche, in dem das piezoelektrische Material (18) ein kristallines oder halb-kristallines ferroelektrisches Material ist, das im Durchschnitt senkrecht zu den gegenüberliegenden Flächen zwischen einerseits dem ersten und dem zweiten leitenden Element (20, 22) und andererseits dem mindestens einen dritten leitenden Element (14, 16) polarisiert ist.

6. Berührungssensor gemäß einem der vorstehenden Ansprüche, in dem das piezoelektrische Material (18) ein kristallines oder halb-kristallines ferroelektrisches Material ist, das entlang der elektrischen Feldlinien, die zwischen den gegenüberliegenden Flächen zwischen einerseits dem ersten und dem zweiten leitenden Element (20, 22) und andererseits dem mindestens einen dritten leitenden Element (14, 16) polarisiert ist, wenn eine Potentialdifferenz zwischen diesen gegenüberliegenden Flächen angelegt wird.

7. Berührungssensor gemäß einem der Ansprüche 5 und 6, in dem das ferroelektrische Material (18) Polyvinylidenfluorid, ein Polyvinylidenfluorid-Copolymer, insbesondere Poly- (VDF-TrFe), Blei-Zirkonattitanat, Baryumtitanat oder eine Mischung daraus enthält.

8. Berührungssensor gemäß einem der vorstehenden Ansprüche, in dem das piezoelektrische Material (18) auf einem flexiblen Substrat (12) ausgeführt wird.

9. Verfahren zur Herstellung eines Berührungssensors nach einem der vorstehenden Ansprüche, das darin besteht:
- eine Schicht aus kristallinem oder halb-kristallinem ferroelektrischen Material (18) herzustellen, die zwischen einerseits dem ersten und zweiten leitenden Element (20, 22) und andererseits dem dritten und vierten leitenden Element (14, 16) angeordnet ist; und
ein elektrisches Feld zwischen einerseits dem ersten und zweiten leitenden Element (20, 22) andererseits dem mindestens einen dritten leitenden Element (14, 16) anzulegen, wobei das elektrische Feld eine Stärke zwischen 30 MV/m und 60 MV/m hat und zwischen 1 Stunde und 8 Stunden mit Erhitzung der ferroelektrischen Materialschicht auf eine Temperatur, die unter der Curie - Temperatur dieses Materials liegt, angelegt wird.

10. Verfahren zur Herstellung eines Berührungssensors gemäß Anspruch 9, bei dem
- ein erstes Verbindungselement (58), das das erste leitende Element (20) und das dritte leitende Element (14) elektrisch verbindet und ein zweites Verbindungselement (62), das das zweite leitende Element (22) und das vierte leitende Element (16) elektrisch verbindet, ausgeführt wird; und
- sich das elektrische Feld durch Anwendung einer Potentialdifferenz zwischen dem ersten und zweiten Verbindungselement (58, 62) ergibt.

11. Verfahren zur Herstellung eines Berührungssensors gemäß einem der Ansprüche 9 oder 10, in dem das ferroelektrische Material (18) Polyvinylidenfluorid, ein Polyvinylidenfluorid-Copolymer, insbesondere Poly-(VDF-TrFe), Blei-Zirkonattitanat, Baryumtitanat oder eine Mischung daraus enthält.

12. Verfahren zur Herstellung eines Berührungssensors gemäß einem der Ansprüche 9, 10 oder 11, in dem die ferroelektrische Materialschicht (18), die zwischen den leitenden Elementen angeordnet ist, ausgeführt wird, indem
- das mindestens eine dritte leitende Element (14, 16) auf einer Seite eines flexiblen Substrats (12) ausgeführt wird;
- in dem die ferroelektrische Materialschicht (18) auf dem dritten leitenden Element (14, 16) und dem Substrat (12) ausgeführt wird; und
- indem das erste und zweite leitende Element (20, 22) auf der ferroelektrischen Schicht (18) ausgeführt werden.

## Claims

1. A touch-sensitive sensor (10) comprising a layer of piezoelectric material (18) interposed between, on the one hand, first and second electrically-conductive elements (20, 22) and, on the other hand, at least one third conductive element (14, 16) comprising a surface opposite at least one of the first and second conductive elements (20, 22)
***characterized:***
**in that** the first and second electrically-conductive elements (20, 22) each comprise a comb (34, 36), and wherein the combs (34, 36) of the first and second conductive elements (20, 22) are interdigited ;
**in that** the piezoelectric material layer (18) is interposed between, on the one hand,
the first and second electrically-conducive elements (20, 22) and, on the other hand,
the third conductive element and a fourth conductive element (14, 16),
**in that** the third and fourth electrically-conductive elements (14, 16) each comprise a comb (46, 48), the combs (46, 48) of the third and fourth conductive elements (14, 16) being interdigited,
**in that**:
▪ teeth (38) of the first conductive element (20) are arranged opposite teeth (52) of the fourth conductive element (16); and
▪ teeth (40) of the second conductive element (22) are arranged opposite teeth (50) of the third conductive element (14).
and **in that** the first conductive element (20) is electrically connected to the third conductive element (14), and wherein the second conductive element (22) is electrically connected to the fourth conductive element (16).

2. The touch-sensitive sensor of claim 1, wherein graphene elements (24) are formed inside of and/or in contact, on the one hand, with the first and second electrically-conductive elements (20, 22) and, on the other hand, with the piezoelectric material layer (18).

3. The touch-sensitive sensor of claim 2, wherein graphene elements (26) are formed inside of and/or in contact, on the one hand, with the second and fourth conductive elements (14, 16) and, on the other hand, with the piezoelectric material layer (18), and opposite the graphene elements (24) formed inside of and/or in contact with the first and second conductive elements (20, 22).

4. The touch-sensitive sensor of any of claims 2 and 3, wherein the elements (24, 26) comprising graphene are graphene pads formed in the conductive elements (14, 16, 20, 22).

5. The touch-sensitive sensor of any of the foregoing claims, wherein the piezoelectric material (18) is a crystalline or semi-crystalline ferroelectric material having a mean polarization perpendicular to the opposite surfaces between, on the one hand, the first and second electrically-conductive elements (20, 22) and, on the other hand, the at least one third conductive element (14, 16).

6. The touch-sensitive sensor of any of the foregoing claims, wherein the piezoelectric material (18) is a crystalline or semi-crystalline ferroelectric material polarized along the electric field lines appearing between the opposite surfaces between, on the one hand, the first and second electrically-conductive elements (20, 22) and, on the other hand, the at least one third conductive element (14, 16) when a voltage is applied between said opposite surfaces.

7. The touch-sensitive sensor of any of claims 5 and 6, wherein the ferroelectric material (18) comprises polyvinylidene fluoride, a copolymer of polyvinylidene fluoride, particularly poly (VDF-TrFe), lead titanium zirconate, barium titanate, or a mixture thereof.

8. The touch-sensitive sensor of any of the foregoing claims, wherein the piezoelectric layer (18) is formed on a flexible substrate (12).

9. A method of manufacturing a touch-sensitive sensor according to any of the foregoing claims, comprising:
▪ forming a layer of crystalline or semi-crystalline ferroelectric material (18) interposed between, on the one hand, the first and second electrically-conductive elements (20, 22) and, on the other hand, the third and fourth conductive element (14, 16); and
▪ applying an electric field between, on the one hand, the first and second electrically-conductive elements (20, 22) and, on the other hand, the at least one third conductive element (14, 16), the electric field having an intensity in the range from 30 MV/m to 60 MV/m, and being applied for between 1 hour and 8 hours, by heating the ferroelectric material layer to a temperature lower than the Curie temperature of said material.

10. The touch-sensitive sensor manufacturing method of claim 9, wherein:
▪ a first connection element (58) is formed by electrically connecting the first conductive element (20) and the third conductive element (14) and a second connection element (62) connecting the second conductive element (22) and the fourth conductive element (16) are formed; and
▪ the electric field is obtained by applying a voltage between the first and second connection elements (58, 62).

11. The touch-sensitive sensor manufacturing method of claim 9 or 10, wherein the ferroelectric material (18) comprises polyvinylidene fluoride, a copolymer of polyvinylidene fluoride, particularly poly (VDF-TrFe), lead titanium zirconate, barium titanate, or a mixture thereof.

12. The touch-sensitive sensor manufacturing method of claim 9, 10, or 11, wherein the ferroelectric material layer (18) interposed between the conductive elements is formed:
▪ by forming the at least one third conductive element (14, 16) on a surface of a flexible substrate (12);
▪ by forming the ferroelectric material layer (18) on the third conductive element (14, 16) and the substrate (12); and
▪ by forming the first and second conductive elements (20, 22) on the ferroelectric layer (18).
